Europäisches Patentamt

European Patent Office

Office européen des brevets

(11) Numéro de publication: **0 218 512 B1**

# FASCICULE DE BREVET EUROPEEN

(45) Date de publication de fascicule du brevet:
**17.07.91**

(51) Int. Cl.⁵: **H03K 23/54**

(21) Numéro de dépôt: **86402056.5**

(22) Date de dépôt: **19.09.86**

(54) Circuit numérique diviseur de fréquence.

(30) Priorité: **19.09.85 FR 8513914**

(43) Date de publication de la demande:
**15.04.87 Bulletin 87/16**

(45) Mention de la délivrance du brevet:
**17.07.91 Bulletin 91/29**

(84) Etats contractants désignés:
**DE GB IT NL**

(56) Documents cités:
**US-A- 3 230 353**
**US-A- 3 835 302**

**PATENTS ABSTRACTS OF JAPAN, vol. 4, no. 8 (E-166), 22 janvier 1980, page 21 E 166; & JP-A-54 147 765**

**IBM TECHNICAL DISCLOSURE BULLETIN, vol. 7, no. 9, Février 1965, page 756, New York, US; C.E. OWEN: "One latch per position counter"**

(73) Titulaire: **ETAT FRANCAIS représenté par le Secrétaire d'Etat aux Postes et Télécommunications et à la Télédiffusion (CENTRE NATIONAL D'ETUDES DES TELECOMMUNICATIONS) 38-40 rue du Général Leclerc**
**F-92131 Issy-les-Moulineaux(FR)**

Titulaire: **TELEDIFFUSION DE FRANCE**
**10, rue d'Oradour sur Glane**
**F-75932 Paris Cédex 15(FR)**

(72) Inventeur: **Carlac'h, Jean-Claude**
**20, Square Auguste Dupouy**
**F-35000 Rennes(FR)**

(74) Mandataire: **Fort, Jacques et al**
**CABINET PLASSERAUD 84, rue d'Amsterdam**
**F-75009 Paris(FR)**

## Description

L'invention concerne les circuits numériques diviseurs de fréquence, permettant de fournir, à partir d'un signal d'horloge mère, à fréquence f, au moins un signal rectangulaire à fréquence plus faible (M/N) f, M étant un nombre entier et N un autre nombre entier, supérieur à M et pair. Elle trouve de nombreuses applications, parmi lesquelles on peut notamment citer la génération, à partir d'un signal d'horloge à fréquence f récupérée par filtrage dans un signal diffusé à la norme C-MAC ou D2-MAC, du signal à la fréquence (2/3) f nécessaire pour tenir compte de la compression du signal de données et de parole diffusé suivant cette norme. On peut également citer la génération, à partir d'une horloge mère à fréquence f, de signaux successifs de décodage de ligne et de colonne à fréquence (M/N) f, décalés les uns par rapport aux autres et sans recouvrement, destinés par exemple à la lecture ou à l'écriture dans une mémoire à organisation matricielle.

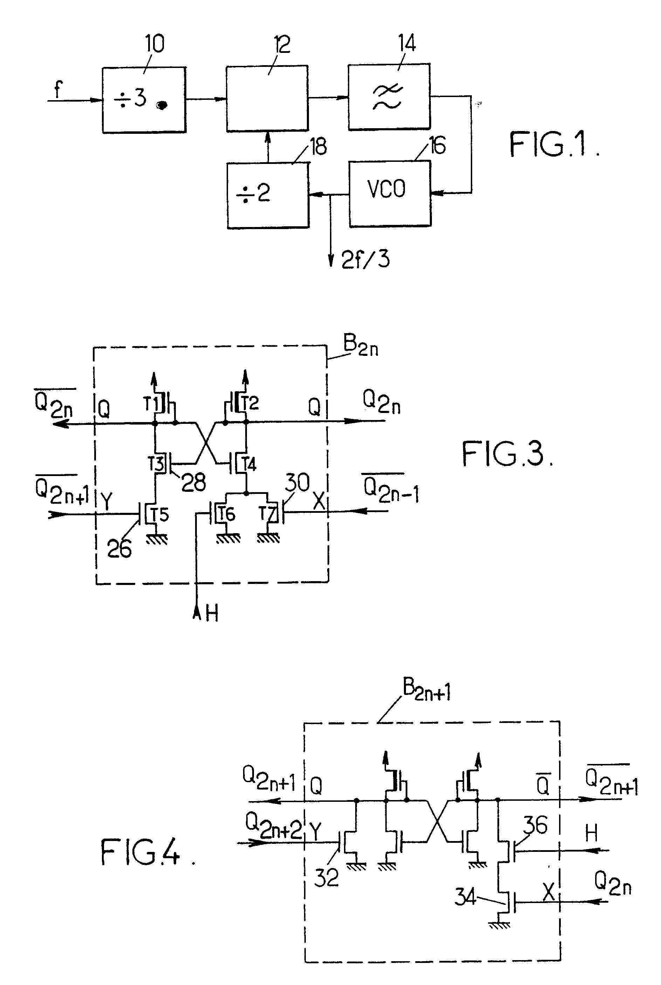

On connait déjà de nombreux circuits diviseurs de fréquence. La plupart utilisent une boucle à verrouillage de phase, fréquemment dénommée PLL, abréviation du nom anglais phase locked loop. La figure 1 montre, à titre d'exemple, un circuit qui fournit la fréquence 2f/3 et qui est utilisable pour générer l'horloge à 13,5 MHz à partir de l'horloge mère à 20,25 Mhz récupérée par un récepteur de télédiffusion dans un signal à la norme C-MAC ou D2-MAC.

Le signal à fréquence f récupéré est appliqué à un diviseur par trois 10 dont la sortie est reliée à une des entrées d'un comparateur de phase 12. Le signal d'erreur fourni par le comparateur 12 est soumis à un filtrage passe-bas dans un filtre 14 destiné à prélever le signal d'erreur de phase. Ce signal d'erreur est appliqué à un oscillateur commandé en tension ou VCO 16. Un diviseur par deux 18 reçoit le signal de l'oscillateur 16 et fournit une tension à fréquence égale à 2f/3, à l'erreur prés, au comparateur de phase 12. La tension de sortie, à fréquence 2f/3, est prélevée à la sortie de l'oscillateur.

Un tel circuit à boucle à verrouillage de phase présente des inconvénients. Les composants analogiques utilisés sont coûteux, difficiles à intégrer à grande échelle sur silicium en même temps que des composants numériques, sensibles au bruit et aux variations de température. Ces inconvénients sont particulièrement graves pour des applications grand public, telles que les récepteurs de télévision. Le domaine de fonctionnement est limité à une bande de fréquence autour d'une valeur nominale. La durée d'accrochage, pendant laquelle le signal de sortie n'est pas utilisable, est notable, ce qui est d'autant plus gênant que la fréquence de travail est élevée, et cette durée est d'autant plus élevée que l'on souhaite disposer d'une bande de fonctionnement large.

On connaît déjà (IBM Technical Disclosure Bulletin, Vol. 7, No. 9, Février 1965) un compteur en anneau permettant de constituer un circuit numérique diviseur suivant le préambule de la revendication 1. Ce compteur en anneau connu permet en effet d'obtenir, à partir d'un signal d'horloge mère à fréquence f, au moins un signal rectangulaire à fréquence plus faible. Toutes les bascules du compteur sont identiques. Il est nécessaire de disposer non seulement d'un signal d'horloge, mais aussi du signal logique complémentaire.

L'invention vise à fournir un circuit diviseur de fréquence simple, entièrement numérique, donc intégrable, ne nécessitant pas de générer un signal complémentaire d'horloge. Elle vise également à fournir un circuit permettant d'obtenir, à partir d'une horloge mère à fréquence f, au moins un signal à fréquence (M/Nf) susceptible de fonctionner dans toute la plage allant de 0 jusqu'à une fréquence maximale ne dépendant que de la rapidité intrinsèque des composants.

Dans ce but, l'invention propose un circuit numérique conforme à la partie caractérisante de la revendication 1.

Un tel circuit est insensible aux différences de vitesse entre les composants logiques, adaptable à la génération de fréquences fractionnaires (M étant différent de 1) aussi bien qu'à celle de plusieurs signaux de fréquence réduite, déphasés les uns par rapport aux autres. bascules en cascade rebouclée, chaque bascule recevant un signal d'entrée de la bascule précédente et de la bascule suivante et recevant le signal d'horloge mère sur une entrée d'horloge, les bascules de rangs pairs étant différentes des bascules de rangs impairs et les signaux à fréquence réduite étant prélevés sur des sorties desdites bascules.

Dans l'application de l'invention, à la génération d'un signal à fréquence (M/N) f, où M est différent de 1, les sorties de plusieurs bascules, fournissant chacune un signal rectangulaire présentant un rapport cyclique dans le rapport 1/N par rapport à l'horloge mère, sont appliquées à une logique combinatoire de type OU donnant un signal de sortie combinant la sortie de plusieurs des bascules de la cascade.

L'invention sera mieux comprise à la lecture de la description qui suit d'un mode particulier d'exécution, donné à titre d'exemple non limitatif. La description se réfère aux dessins qui l'accompagnent, dans lesquels :

- La Figure 1, déjà mentionnée, est un schéma de principe d'un multiplicateur de fréquence par 2/3 de type connu, comportant une boucle à verrouillage de phase.

- La Figure 2 est un synoptique d'un circuit diviseur de fréquence suivant un mode particulier de réalisation de l'invention, réalisant la division par multiplication par le facteur 2/3,
- Les Figures 3 et 4 sont des schémas fonctionnels montant une constitution possible des portes paires et impaires du circuit de la Figure 2,
- Les Figures 5 et 6 donnent respectivement les tables de vérité des bascules paires et impaires des Figures 3 et 4,
- La Figure 7 est un chronogramme du circuit de la Figure 2.

Le circuit montré en Figure 2 est destiné à fournir, à partir d'un signal à fréquence f fourni par une horloge mère H (qui peut être un circuit de récupération de la base de temps dans un signal reçu), un signal à fréquence 2f/3. Il peut être regardé comme constitué d'un système séquentiel 20 de $N = 6$ bascules en cascade, d'une logique combinatoire 22 et d'un montage 24 d'initialisation des bascules.

Les six bascules de la cascade 20 comprennent trois bascules paires $B_0$, $B_2$, $B_4$ et trois bascules impaires $B_1$, $B_3$, $B_5$, de type différent de celui des bascules paires. L'alternance de bascules de types différents permet, comme on le verra, de réduire le nombre de couches logiques à celui qui est nécessaire pour constituer les points de mémorisation alimentant la logique combinatoire et d'éviter de devoir générer le complément logique /H de l'horloge mère H, ce qui constitue des facteurs de simplification du circuit, de réduction de la surface occupée sur une tranche de semiconducteur et de la puissance consommée, et d'augmentation de la rapidité.

Plusieurs constitutions des bascules sont possibles. On peut notamment utiliser les constitutions et liaisons montrées en Figure 3 et 4 pour des circuits réalisés en transistors "NMOS enrichis et appauvris". La Figure 3 montre une bascule paire $B_{2n}$ et les liaisons sont identifiées de façon correspondante, 2n pouvant prendre les valeurs 0, 2 et 4. La Figure 4 montre une bascule impaire $B_{2n+1}$, $2n+1$ pouvant prendre les valeurs 1, 3 et 5. Dans tous les cas les indices portés sur les entrées et sorties doivent être considérés modulo 6.

Les bascules ont toutes le même coeur, constitué classiquement de quatre transistors C-MOS montés deux à deux en série, avec deux couplages croisés grille-drain. Les sorties Q et /Q des bascules sont prélevées sur les points milieux entre transistors en série.

Dans une bascule paire $B_{2n}$ (Figure 3), le transistor amont du montage série sur lequel est prélevée la sortie /Q est commandé par la sortie /Q de la bascule suivante $/Q_{2n+1 \text{ (modulo 6)}}$ par l'intermédiaire d'un transistor 26. Le transistor amont de l'autre montage série est commandé par le signal d'horloge (entrée H) et la sortie $/Q_{2n-1}$ de la bascule précédente (entrée X) par l'intermédiaire de transistors respectifs 28 et 30.

Dans une bascule impaire $B_{2n+1}$ (Figure 4) les signaux de commande sont appliqués sur les couplages croisés. La sortie $Q_{2n+2 \text{ (modulo 6)}}$ de la bascule suivante est appliquée, par l'intermédiaire d'un transistor 32, sur l'entrée Y correspondant à la jonction de prélèvement de la sortie Q de la bascule $B_{2n+1}$. Les entrées H et X de la bascule reçoivent le signal d'horloge H et la sortie Q de la bascule $B_{2n}$. Ces signaux de commande sont appliqués, par l'intermédiaire de transistors en cascade 34 et 36, sur la jonction correspondant à la sortie /Q de la bascule $B_{2n+1}$.

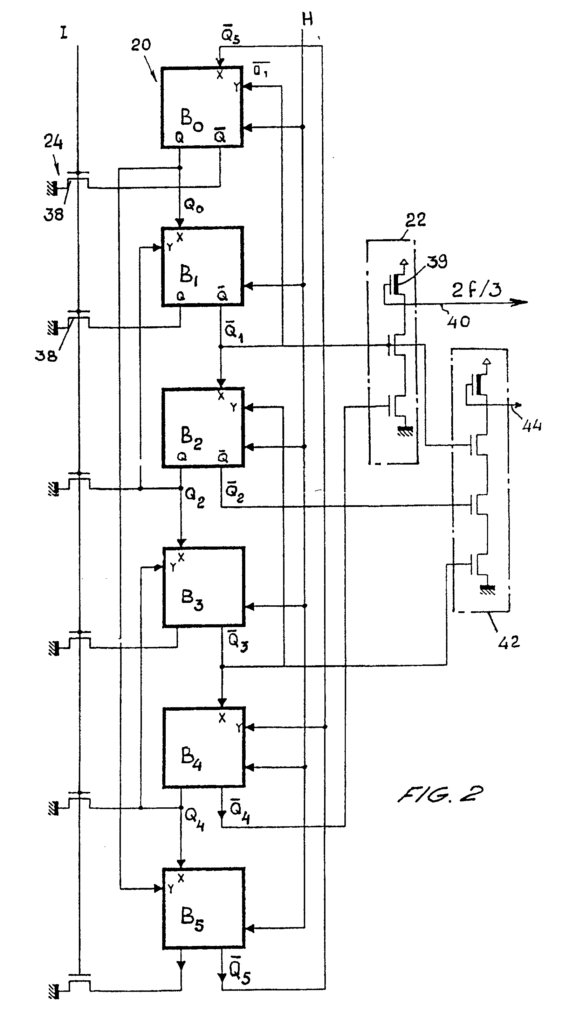

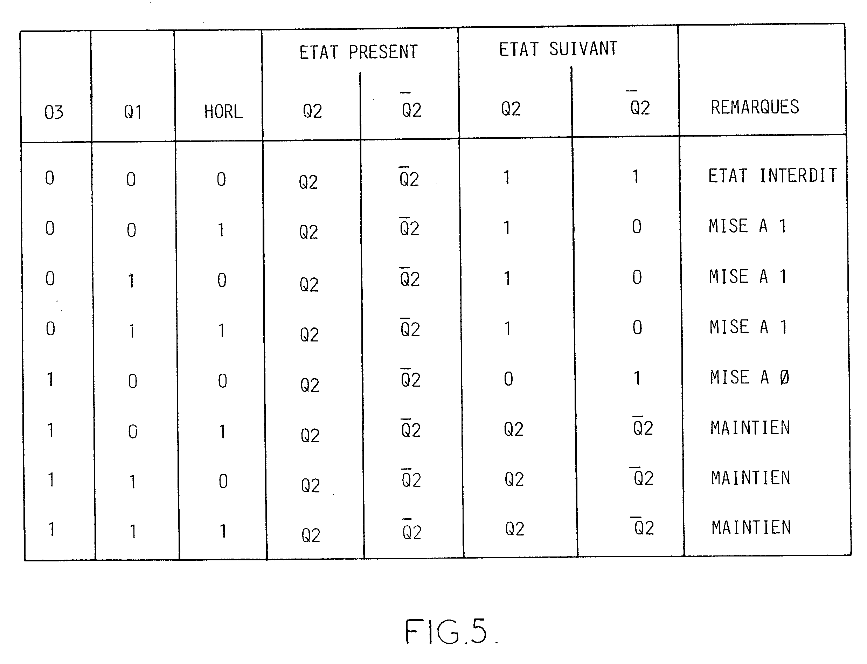

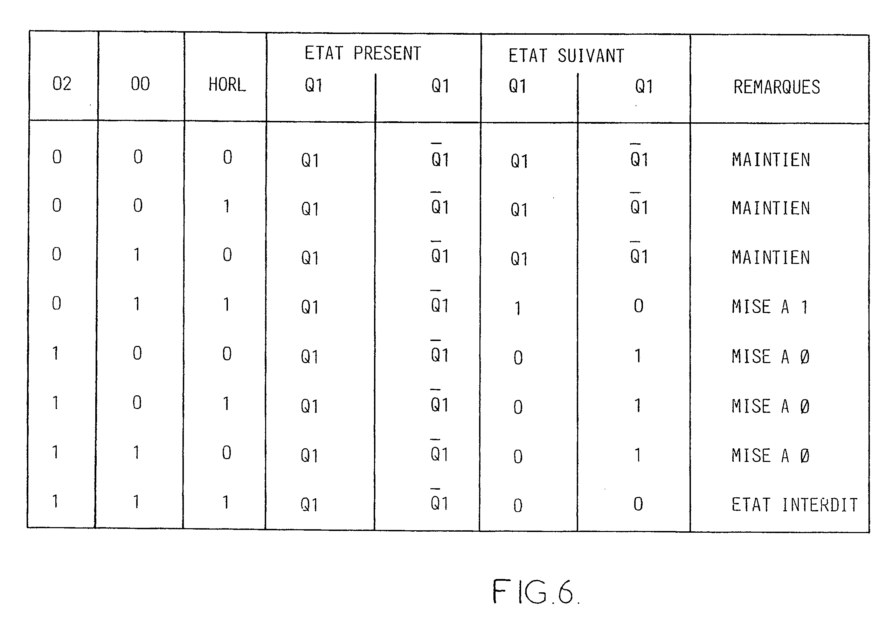

De façon plus générale, on pourra utiliser des bascules dont les tables de vérité sont celles données en Figures 5 et 6 de la demande. Pour plus de clarté, les tables représentées correspondent aux bascules B2 et B1 mais elles sont directement transposables aux autres bascules paires et impaires, en notant que,

- pour la bascule $B_1$ :  ·
  $2n+2 = 2, 2n+1 = 1, 2n = 0$
- pour la bascule $B_2$,
  $2n+1 = 3, 2n = 2, 2n-1 = 1$

Le montage 24 d'initialisation des bascules comprend un transistor 38 affecté à chaque bascule $B_0,...B_5$. La source de tous les transistors 38 est à la masse et les grilles sont attaquées en parallèle par le signal d'initialisation I. Le drain du transistor 38 associé à la bascule B0 est relié à la sortie /Q de cette bascule. Pour toutes les autres bascules, le drain du transistor 38 est relié à la sortie Q.

Le fonctionnement du circuit est le suivant, lorsqu'il reçoit des impulsions d'horloge H à fréquence f.

Une phase d'initialisation est nécessaire, au cours de laquelle le signal I doit rester au niveau logique 1 suffisamment longtemps pour forcer l'état de toutes les bascules. La bascule B0 est forcée à l'état les autres bascules sont forcées à l'état 0. En d'autres termes, on a $Qi = 0$ et $/Qi = 1$ pour toutes les valeurs i différentes de 0.

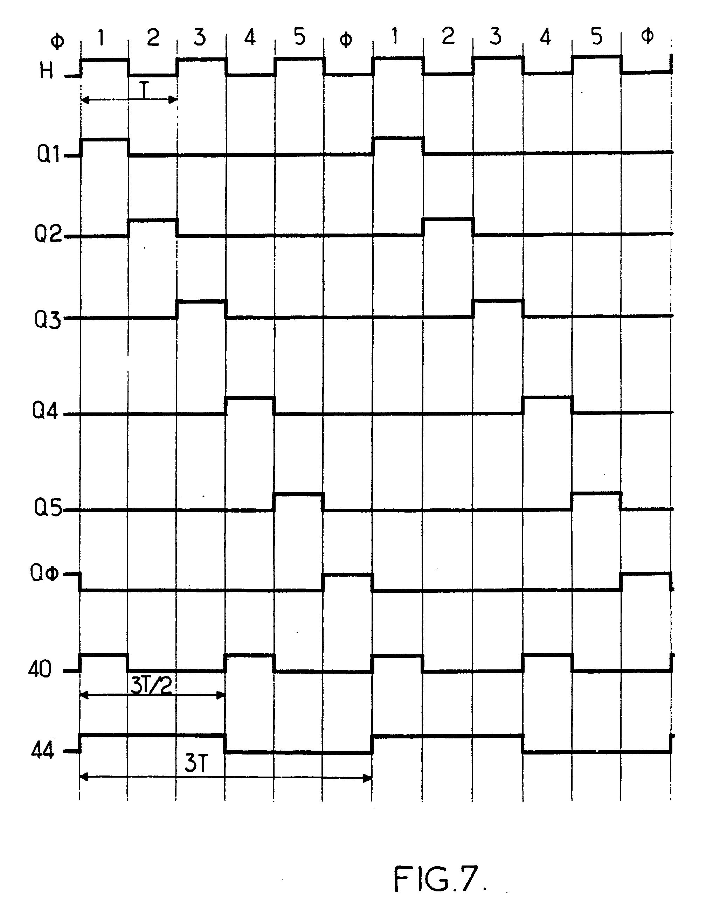

Dès la fin de l'initialisation, au premier front montant d'horloge (c'est-à-dire lorsque le signal H passe de 0 à 1, à l'instant t0 sur la Figure 7), Q0 repasse à 0 et Q1 passe à 1. Les autres sorties $Q_i$ restent à 0. Au bout d'une demi période d'horloge T/2 sur le front descendant de l'horloge, la sortie Q1 repasse à 0 et la sortie Q2 monte à 1. La séquence se poursuit sur les coups d'horloge suivants et on voit sur la Figure 7 que les sorties Q des différentes bascules passent à 1 en séquence et restent au niveau 1 pendant une demi période d'horloge. Grâce à l'alternance de deux types d'horloge, la montée au niveau 1 intervient alternativement sur un front montant et un front descendant d'horloge, sans qu'il soit nécessaire de générer le signal /H.

Dans le cas où l'on veut disposer d'un signal à fréquence 2f/3, la logique combinatoire peut se limiter à une porte ET NON dont on va voir qu'elle remplit en fait la fonction OU. Cette logique est constituée de deux transistors MOS de type n dont les grilles reçoivent respectivement les sorties /Q1 et /Q4 montées en cascade avec un transistor de sortie 38 de type complémentaire de celui des précédents. Le signal à fréquence 2f/3 apparaît sur la sortie 40 (ligne 40 sur la Figure 7), avec un rapport cyclique égal à 1/3.

D'autres montages permettraient d'obtenir des fréquences différentes. On peut par exemple obtenir une fréquence f/3 et un rapport cyclique égal à 1/2 à l'aide d'une logique 42 constituée encore par une porte ET NON. Les grilles de trois transistors en cascade de cette porte reçoivent respectivement les sorties /Q1, /Q2, et /Q3. Sur la sortie 44 de la logique apparaît le signal à fréquence f/3.

On voit encore, sur le chronogramme de la Figure 7, que l'on obtient sur les sorties Q des bascules successives des signaux adjacents ayant un rapport cyclique égal à 1/6, ne présentant aucun recouvrement, apparaissant en séquence. On peut utiliser les signaux successifs pour décoder des adresses séquentiellement : on écrit ou on lit successivement des adresses n, puis n + 2, puis n + 4, etc.. on peut ainsi gérer de façon simple une mémoire dite FIFO, c'est-à-dire "premier entré-premier sorti". Il suffit de prendre uniquement les sorties Q des bascules impaires pour avoir des intervalles de temps égaux à la durée d'une impulsion de commande entre impulsions successives. On peut ainsi garantir qu'il n'y aura qu'un seul signal de décodage actif par ligne ou/et par colonne et éviter les erreurs de lecture et d'écriture.

**Revendications**

1. Circuit numérique diviseur de fréquence, permettant de fournir, à partir d'un signal d'horloge mère, à fréquence f, au moins un signal rectangulaire à fréquence plus faible M•f/N, M étant un nombre entier et N un autre nombre entier, supérieur à M et pair, comportant un système séquentiel (20) constitué d'un nombre pair N de bascules (B0-B5) en cascade rebouclée en anneau, chaque bascule recevant un signal d'entrée provenant de la bascule précédente sur une entrée de données et un signal d'entrée provenant de la bascule suivante sur l'autre entrée de données, et recevant le signal d'horloge mère (H) sur une entrée d'horloge, caractérisé en ce que les bascules de rangs pairs sont différentes des bascules de rangs impairs de façon que leurs passages au niveau 1, ou au niveau 0, interviennent respectivement en réponse aux fronts montants et descendants d'horloge, suivant leur parité, et en ce que les signaux à fréquence plus faible sont constitués à partir des signaux de sortie, à fréquence f/N, desdites bascules.

2. Circuit numérique diviseur de fréquence selon la revendication 1 de génération d'un signal à fréquence (M/N) f, où M est différent de 1, caractérisé en ce les sorties de plusieurs bascules, fournissant chacune un signal rectangulaire présentant un rapport cyclique dans le rapport 1/N par rapport à l'horloge mère, sont appliquées à une logique combinatoire de type OU donnant un signal de sortie combinant la sortie de plusieurs des bascules de la cascade.

3. Circuit numérique diviseur de fréquence selon la revendication 2 de génération de la fréquence 2f/3, caractérisé en ce que la cascade comprend six bascules et en ce que la logique (22) comprend une porte ET-NON à deux entrées reliées respectivement aux sorties /Q de deux bascules d'ordre i et i + 3.

4. Circuit numérique diviseur de fréquence selon la revendication 1 de génération de signaux successifs de décodage de ligne et de colonne à fréquence (M/N) f, décalés les uns par rapport aux autres et sans recouvrement, caractérisé en ce que ses sorties sont ventilées par les sorties Q et /Q d'une bascule sur deux de la cascade.

5. Circuit numérique diviseur de fréquence selon l'une quelconque des revendications précédentes, caractérisé en ce que les bascules paires sont constituées pour présenter la table de vérité suivante :

EP 0 218 512 B1

| O3 | Q1 | HORL | ETAT PRESENT | | ETAT SUIVANT | | REMARQUES |
|---|---|---|---|---|---|---|---|
| | | | Q2 | $\overline{Q2}$ | Q2 | $\overline{Q2}$ | |
| 0 | 0 | 0 | Q2 | $\overline{Q2}$ | 1 | 1 | ETAT INTERDIT |
| 0 | 0 | 1 | Q2 | $\overline{Q2}$ | 1 | 0 | MISE A 1 |
| 0 | 1 | 0 | Q2 | $\overline{Q2}$ | 1 | 0 | MISE A 1 |
| 0 | 1 | 1 | Q2 | $\overline{Q2}$ | 1 | 0 | MISE A 1 |
| 1 | 0 | 0 | Q2 | $\overline{Q2}$ | 0 | 1 | MISE A 0 |
| 1 | 0 | 1 | Q2 | $\overline{Q2}$ | Q2 | $\overline{Q2}$ | MAINTIEN |
| 1 | 1 | 0 | Q2 | $\overline{Q2}$ | Q2 | $\overline{Q2}$ | MAINTIEN |
| 1 | 1 | 1 | Q2 | $\overline{Q2}$ | Q2 | $\overline{Q2}$ | MAINTIEN |

et en ce que les bascules impaires sont constituées pour présenter la table de vérité suivante :

| O2 | O0 | HORL | ETAT PRESENT | | ETAT SUIVANT | | REMARQUES |
|---|---|---|---|---|---|---|---|
| | | | Q1 | $\overline{Q1}$ | Q1 | $\overline{Q1}$ | |
| 0 | 0 | 0 | Q1 | $\overline{Q1}$ | Q1 | $\overline{Q1}$ | MAINTIEN |
| 0 | 0 | 1 | Q1 | $\overline{Q1}$ | Q1 | $\overline{Q1}$ | MAINTIEN |
| 0 | 1 | 0 | Q1 | $\overline{Q1}$ | Q1 | $\overline{Q1}$ | MAINTIEN |
| 0 | 1 | 1 | Q1 | $\overline{Q1}$ | 1 | 0 | MISE A 1 |
| 1 | 0 | 0 | Q1 | $\overline{Q1}$ | 0 | 1 | MISE A 0 |
| 1 | 0 | 1 | Q1 | $\overline{Q1}$ | 0 | 1 | MISE A 0 |
| 1 | 1 | 0 | Q1 | $\overline{Q1}$ | 0 | 1 | MISE A 0 |
| 1 | 1 | 1 | Q1 | $\overline{Q1}$ | 0 | 0 | ETAT INTERDIT |

où les notations Q1 et Q2 désignent les sorties des bascules.

6. Circuit numérique diviseur de fréquence suivant l'une quelconque des revendications précédentes, caractérisé en ce qu'il comprend de plus un montage d'auto-initialisation permettant de forcer simultanément à 0 la sortie Q d'une des bascules et à 1 la sortie Q de toutes les autres.

7. Circuit selon l'une quelconque des revendications précédentes, caractérisé en ce qu'il est constitué de transistors NMOS.

8. Circuit suivant la revendication 7, caractérisé en ce chacune des bascules comporte un coeur constitué de quatre transistors NMOS montés deux à deux en série, avec deux couplages croisés grille-drain, en ce que dans les bascules paires le transistor amont du montage série sur lequel est prélevée la sortie /Q est commandé par la sortie /Q de la bascule suivante tandis que dans les bascules impaires la jonction de prélèvement de la sortie Q reçoit la sortie Q de la bascule suivante.

9. Circuit suivant la revendication 8, caractérisé en ce que, dans chaque bascule paire, le transistor amont du montage série sur lequel est prélevée la sortie Q est commandé par le signal d'horloge et par la sortie Q de la bascule précédente par l'intermédiaire de transistors respectifs (28,30).

10. Circuit suivant la revendication 8 ou 9, caractérisé en ce que, dans chaque bascule impaire, l'entrée correspondant à la sortie /Q de la bascule reçoit le signal d'horloge et la sortie de la bascule précédente par l'intermédiaire de transistors en cascade (34,36).

**Claims**

1. Frequency divider digital circuit for delivering, from a parent clock signal, at a frequency f, au least one rectangular shaped signal having a lower frequency M f/N, M being an integer and N another integer greater than M and even, comprising a sequential system (20) consisting of an even number N of cascaded flip-flops (B0-B5) looped to form a ring, each flip-flop receiving an input signal from the preceding flip-flop on a data input and an input signal from the following flip-flop on the other data input and receiving the signal from the parent clock (H) on a clock input,
   characterized in that the even flip-flops differ from the odd flip-flops for their one-crossing or their zero crossing respectively occur responsive to the up-going and down-going clock edges, depending upon whether they are even or odd, and in that the signals at a lower frequency are formed from the output signals, at frequency f/N, of said flip-flops.

2. Frequency divider digital circuit acording to claim 1 for delivering an output signal at frequency (M/N) f where M is an integer different from 1,
   characterized in that the outputs of a plurality of flip-flops each delivering a rectangular signal having a duty ratio equal to 1/N of that of the parent clock signal, are applied to a combination logic of OR type giving an output signal combining the outputs of several of the flip-flops of the cascade.

3. Frequency divider digital circuit according to claim 2 for generating frequency 2f/3,
   characterized in that the cascade comprises six flip-flops and in that the logic (22) comprises a NAND gate having two inputs respectively connected to the /Q outputs of two of said flip-flops numbered i and i + 3.

4. Frequency divider digital circuit according to claim 1 for generating successive signals for line and column decoding at frequency (M/N) f offset with respect to each other and without overlap,
   characterized in that its inputs are distributed by the outputs Q and /Q of one flip-flop out of two of the cascade.

5. Frequency divider digital circuit according to any one of the preceding claims,
   characterized in that the even flip-flops are arranged for having the following truth table:

| Q3 | Q1 | CLOCK | PRESENT STATE | | NEXT STATE | | REMARKS |
|----|----|-------|----|----|----|----|---------|
| | | | Q2 | $\overline{Q2}$ | Q2 | $\overline{Q2}$ | |
| 0 | 0 | 0 | Q2 | $\overline{Q2}$ | 1 | 1 | FORBIDDEN STATE |
| 0 | 0 | 1 | Q2 | $\overline{Q2}$ | 1 | 0 | RESET TO 1 |
| 0 | 1 | 0 | Q2 | $\overline{Q2}$ | 1 | 0 | RESET TO 1 |
| 0 | 1 | 1 | Q2 | $\overline{Q2}$ | 1 | 0 | RESET TO 1 |
| 1 | 0 | 0 | Q2 | $\overline{Q2}$ | 0 | 1 | RESET TO Ø |
| 1 | 0 | 1 | Q2 | $\overline{Q2}$ | Q2 | $\overline{Q2}$ | UNCHANGED |
| 1 | 1 | 0 | Q2 | $\overline{Q2}$ | Q2 | $\overline{Q2}$ | UNCHANGED |
| 1 | 1 | 1 | Q2 | $\overline{Q2}$ | Q2 | $\overline{Q2}$ | UNCHANGED |

and in that the odd flip-flops are arranged for having the following truth table:

| Q2 | Q0 | CLOCK | PRESENT STATE | | NEXT STATE | | REMARKS |
|----|----|-------|----|----|----|----|---------|
| | | | Q1 | $\overline{Q1}$ | Q1 | $\overline{Q1}$ | |
| 0 | 0 | 0 | Q1 | $\overline{Q1}$ | Q1 | $\overline{Q1}$ | UNCHANGED |
| 0 | 0 | 1 | Q1 | $\overline{Q1}$ | Q1 | $\overline{Q1}$ | UNCHANGED |
| 0 | 1 | 0 | Q1 | $\overline{Q1}$ | Q1 | $\overline{Q1}$ | UNCHANGED |
| 0 | 1 | 1 | Q1 | $\overline{Q1}$ | 1 | 0 | RESET TO 1 |
| 1 | 0 | 0 | Q1 | $\overline{Q1}$ | 0 | 1 | RESET TO Ø |
| 1 | 0 | 1 | Q1 | $\overline{Q1}$ | 0 | 1 | RESET TO Ø |
| 1 | 1 | 0 | Q1 | $\overline{Q1}$ | 0 | 1 | RESET TO Ø |
| 1 | 1 | 1 | Q1 | $\overline{Q1}$ | 0 | 0 | FORBIDDEN STATE |

wherein Q1 and Q2 designate the outputs of the flip-flops.

6.  Frequency divider digital circuit according to any one of the preceding claims,
    characterized in that it further comprises a self initialization circuit for simultaneously forcing the Q output of one of the flip-flops to zero and the Q outputs of all other flip-flops to one.

7. Circuit according to any one of the preceding claims,
   characterized in that it consists of N-MOS transistors.

8. Circuit according to claim 7,
   characterized in that each of the flip-flops has a core consisting of four N-MOS transistors, the transistors in each pair being in series relation, with two crossed gate-drain couplings, in that, in the even-numbered flip-flops, the upstream transistor of the series arrangement from which the /Q output is taken is controlled by the /Q output of the following flip-flop while, in the odd numbered flip-flops, the junction from which the Q output of the flip-flop is taken receives the Q output of the next flip-flop.

9. Circuit according to claim 8,
   characterized in that, in each even-numbered flip-flop, the upstream transistor of the series connection, from which the Q output is taken, is controlled by the clock signal and by the Q output of the preceding flip-flop through respective transistors (28, 30).

10. Circuit according to claim 8 or 9,
   characterized in that, in each odd numbered flip-flop, the input corresponding to the /Q output of the flip-flop receives the clock signal and the output of the preceding flip-flop through cascaded transistors (34, 36).

**Patentansprüche**

1. Digitale Frequenzteilerschaltung, die aus einem Haupttaktsignal mit der Frequenz f wenigstens ein Rechtecksignal mit der niedrigeren Frequenz M f/N erzeugt, wobei M eine ganze Zahl und N eine andere ganze ist, die geradzahlig und größer als M ist, mit einem Folgesystem (20), das aus einer geraden Zahl N von Kippstufen (B0-B5) besteht, die in einer Ringschleife in Kaskade angeordnet sind, wobei jede Kippstufe an einem Dateneingang ein von der vorgeordneten Kippstufe kommendes Eingangssignal und an dem anderen Dateneingang ein von der nachgeordneten Kippstufe kommendes Signal und an einem Takteingang das Haupttaktsignal (H) aufnimmt, dadurch gekennzeichnet, daß die Kippstufen mit geradzahligen Rangstufen sich von den Kippstufen mit ungeradzahligen Rangstufen darin unterscheiden, daß ihre Übergänge zu dem Pegel "1" oder dem Pegel "0" je nach ihrer Parität in Abhängigkeit von den Anstiegsflanken bzw. den Abstiegsflanken des Taktsignals auftreten, und daß die Signale mit der niedrigstens Frequenz aus den Ausgangssignalen mit der Frequenz f/N der Kippstufen gebildet werden.

2. Digitale Frequenzteilerschaltung nach Anspruch 1 zur Erzeugung eines Signals mit der Frequenz (M/N) f, wobei M von 1 verschieden ist, dadurch gekennzeichnet, daß die Ausgänge mehrerer Kippstufen, die jeweils ein Rechtecksignal liefern, das ein zyklisches Verhältnis 1/N relativ zu dem Haupttaktsignal hat, mit einer kombinatorischen ODER-Logikschaltung verbunden sind, die ein Ausgangssignal liefert, das eine Kombination des Ausgangs mehrerer Kippstufen der Kaskade darstellt.

3. Digitale Frequenzteilerchaltung nach Anspruch 2 zur Erzeugung der Frequenz 2f/3, dadurch gekennzeichnet, daß die Kaskade sechs Kippstufen umfaßt und daß die Logikschaltung (22) ein UND-NICHT-Gatter an zwei Eingängen aufweist, die mit den Ausgängen /Q zweier Kippstufen mit den Ordnungszahlen i bzw. i + 3 verbunden sind.

4. Digitale Frequenzteilerschaltung nach Anspruch 1 zur Erzeugung von aufeinanderfolgenden Zeilen- und Spaltendekodiersignalen mit der Frequenz (M/N) f, die gegeneinander versetzt sind und einander nicht überlappen, dadurch gekennzeichnet, daß ihre Ausgänge von den Ausgängen Q und /Q jeder zweiten Kippstufe der Kaskade gebildet sind.

5. Digitale Frequenzteilerschaltung nach einem der vorhergehenden Ansprüche, dadurch gekennzeichnet, daß die geradzahligen Kippstufen so angeordnet sind, daß sie folgender Wahrheitstabelle entsprechen:

| O3 | Q1 | Takt | Gegenwärt. Zustand | | nachfolg. Zustand | | Bemerkungen |
|----|----|------|--------|------|------|------|-------------|
|    |    |      | $\bar{Q}2$ | Q2 | Q2 | $\bar{Q}2$ | |
| 0 | 0 | 0 | Q2 | $\bar{Q}2$ | 1 | 1 | verbot. Zust. |
| 0 | 0 | 1 | Q2 | $\bar{Q}2$ | 1 | 0 | A 1 gesetzt |
| 0 | 1 | 0 | Q2 | $\bar{Q}2$ | 1 | 0 | A 1 gesetzt |
| 0 | 1 | 1 | Q2 | $\bar{Q}2$ | 1 | 0 | A 1 gesetzt |
| 1 | 0 | 0 | Q2 | $\bar{Q}2$ | 0 | 1 | A 0 gesetzt |
| 1 | 0 | 1 | Q2 | $\bar{Q}2$ | Q2 | $\bar{Q}2$ | Halten |
| 1 | 1 | 0 | Q2 | $\bar{Q}2$ | Q2 | $\bar{Q}2$ | Halten |
| 1 | 1 | 1 | Q2 | $\bar{Q}2$ | Q2 | $\bar{Q}2$ | Halten |

und daß die ungeradzahligen Kippstufen so angeordnet sind, daß sie folgender Wahrheitstabelle entsprechen:

| O2 | O0 | Takt | Gegenwärt. Zustand | | nachfolg. Zustand | | Bemerkungen |
|----|----|------|--------|------|------|------|-------------|
|    |    |      | Q1 | $\bar{Q}1$ | Q1 | $\bar{Q}1$ | |
| 0 | 0 | 0 | Q1 | $\bar{Q}1$ | Q1 | $\bar{Q}1$ | Halten |
| 0 | 0 | 1 | Q1 | $\bar{Q}1$ | Q1 | $\bar{Q}1$ | Halten |
| 0 | 1 | 0 | Q1 | $\bar{Q}1$ | Q1 | $\bar{Q}1$ | Haltne |
| 0 | 1 | 1 | Q1 | $\bar{Q}1$ | 1 | 0 | A 1 gesetzt |
| 1 | 0 | 0 | Q1 | $\bar{Q}1$ | 0 | 1 | A 0 gesetzt |
| 1 | 0 | 1 | Q1 | $\bar{Q}1$ | 0 | 1 | A 0 gesetzt |
| 1 | 1 | 0 | Q1 | $\bar{Q}1$ | 0 | 1 | A 0 gesetzt |
| 1 | 1 | 1 | Q1 | $\bar{Q}1$ | 0 | 0 | verbot. Zust. |

wobei die Notationen Q1 und Q2 die Ausgänge der Kippstufen bezeichnen.

6. Digitale Frequenzteilerschaltung nach einem der vorhergehenden Ansprüche, dadurch gekennzeichnet, daß weiterhin eine Vorrichtung zur Selbstinitialisierung vorgesehen ist, die es ermöglicht, zwangsweise gleichzeitig den Ausgang Q einer der Kippstufen auf "0" und den Ausgang Q aller anderen Kippstufen auf "1" zu setzen.

7. Digitale Frequenzteilerschaltung nach einem der vorhergehen den Ansprüche, dadurch gekennzeichnet, daß sie aus NMOS-Transistoren besteht.

8. Digitale Frequenzteilerschaltung nach Anspruch 7, dadurch gekennzeichnet, daß jede Kippstufe eine Kernschaltung aufweist, die aus vier NMOS-Transistoren besteht, die mit zwei gekreuzten Gate-Drain-Kopplungen paarweise in Reihe geschaltet sind, und daß in den geradzahligen Kippstufen der obere Transistor der Reihenschaltung, an dem das Ausgangssignal /Q abgenommen wird , von dem Ausgangssignal /Q der nachfolgenden Kippstufe gesteuert wird, während in den ungeradzahligen Kippstufen der Verbindungspunkt für den Abgriff des Ausgangssignals Q das Ausgangssignal Q der nachfolgenden Kippstufe aufnimmt.

9. Digitale Frequenzteilerschaltung nach Anspruch 8, dadurch gekennzeichnet, daß in jeder geradzahligen Kippstufe der obere Transistor der Reihenschaltung, an dem das Ausgangssignal Q abgegriffen wird, durch das Taktsignal und das Ausgangssignal Q der vorhergehenden Kippstufe jeweils über Transistoren (28, 30) gesteuert wird.

10. Digitale Frequenzteilerschaltung nach Anspruch 8 oder 9, dadurch gekennzeichnet, daß in jeder ungeradzahligen Kippstufe der dem Ausgang /Q der Kippstufe entsprechende Eingang das Taktsignal und das Ausgangssignal der vorhergehenden Kippstufe über in Kaskade geschaltete Transistoren (34, 36) aufnimmt.

FIG.1.

FIG.3.

FIG.4.

FIG. 2

| 03 | Q1 | HORL | ETAT PRESENT | | ETAT SUIVANT | | REMARQUES |
|---|---|---|---|---|---|---|---|
| | | | Q2 | $\overline{Q2}$ | Q2 | $\overline{Q2}$ | |
| 0 | 0 | 0 | Q2 | $\overline{Q2}$ | 1 | 1 | ETAT INTERDIT |
| 0 | 0 | 1 | Q2 | $\overline{Q2}$ | 1 | 0 | MISE A 1 |
| 0 | 1 | 0 | Q2 | $\overline{Q2}$ | 1 | 0 | MISE A 1 |
| 0 | 1 | 1 | Q2 | $\overline{Q2}$ | 1 | 0 | MISE A 1 |
| 1 | 0 | 0 | Q2 | $\overline{Q2}$ | 0 | 1 | MISE A Ø |
| 1 | 0 | 1 | Q2 | $\overline{Q2}$ | Q2 | $\overline{Q2}$ | MAINTIEN |
| 1 | 1 | 0 | Q2 | $\overline{Q2}$ | Q2 | $\overline{Q2}$ | MAINTIEN |
| 1 | 1 | 1 | Q2 | $\overline{Q2}$ | Q2 | $\overline{Q2}$ | MAINTIEN |

FIG.5.

EP 0 218 512 B1

| 02 | 00 | HORL | ETAT PRESENT | | ETAT SUIVANT | | REMARQUES |
|---|---|---|---|---|---|---|---|
| | | | Q1 | $\overline{Q1}$ | Q1 | $\overline{Q1}$ | |
| 0 | 0 | 0 | Q1 | $\overline{Q1}$ | Q1 | $\overline{Q1}$ | MAINTIEN |
| 0 | 0 | 1 | Q1 | $\overline{Q1}$ | Q1 | $\overline{Q1}$ | MAINTIEN |
| 0 | 1 | 0 | Q1 | $\overline{Q1}$ | Q1 | $\overline{Q1}$ | MAINTIEN |
| 0 | 1 | 1 | Q1 | $\overline{Q1}$ | 1 | 0 | MISE A 1 |
| 1 | 0 | 0 | Q1 | $\overline{Q1}$ | 0 | 1 | MISE A Ø |
| 1 | 0 | 1 | Q1 | $\overline{Q1}$ | 0 | 1 | MISE A Ø |
| 1 | 1 | 0 | Q1 | $\overline{Q1}$ | 0 | 1 | MISE A Ø |
| 1 | 1 | 1 | Q1 | $\overline{Q1}$ | 0 | 0 | ETAT INTERDIT |

FIG.6.

EP 0 218 512 B1

FIG.7.